# EUROPEAN PATENT APPLICATION

(11) **EP 4 722 013 A1**
(43) Date of publication of application: **08.04.2026**
(21) Application number: 24203791.9
(22) Date of filing: 01.10.2024
(51) Int. Cl.: B60K 35/10, B60K 35/22, B60K 35/26, B60W 50/00, B60W 50/14

(54) **METHOD FOR PROVIDING A DESCRIPTION OF A FUNCTIONALITY OF A VEHICLE TO A USER OF THE VEHICLE, DATA PROCESSING APPARATUS, COMPUTER PROGRAM, COMPUTER-READABLE STORAGE MEDIUM, AND VEHICLE**

(71) Applicant: Volvo Car Corporation, 405 31 Göteborg (SE)
(72) Inventor: WICKMAN, Casper, 40531 Göteborg (SE)
(74) Representative: Kransell & Wennborg KB

(57) **Abstract**

The disclosure relates to a method for providing a description of a functionality of a vehicle (10) to a user (24) of the vehicle (10). The method comprises obtaining first data (D1) indicative of a current user behavior. The method also comprises obtaining second data (D2) indicative of a historic user behavior. The historic user behavior is associated with the user (24) located inside the vehicle (10) while the vehicle (10) is in a non-driving mode. Moreover, the method comprises determining a likelihood (LH) that the user will stay inside the vehicle (10) while the vehicle (10) is in the non-driving mode based on the first data (D1) and based on the second data (D2). Furthermore, the method comprises triggering a provision of the description of the functionality of the vehicle (10), if said determined likelihood (LH) exceeds a predefined likelihood threshold. The disclosure also relates to a data processing apparatus (34), a computer program (44), and to a computer-readable storage medium (42) for executing said method. Finally, a vehicle (10) comprising said data processing apparatus (34) is described.

## Description

### TECHNICAL FIELD

The present disclosure relates to a method for providing a description of a functionality of a vehicle to a user of the vehicle.

Moreover, the present disclosure is directed to a data processing apparatus, a computer program, a computer-readable storage medium and to a vehicle.

### BACKGROUND ART

Today's vehicles come with a broad variety of functionalities. However, a user of such a vehicle may not make efficient and/or effective use of all available functionalities of the vehicle.

On the one hand, this may be due to the fact that the user is not aware of all functionalities of the vehicle or does not know how to activate and/or use them.

On the other hand, the user may feel insecure when activating a certain functionality of the vehicle while driving. This may be the case because the activation of the functionality distracts the user's attention from a driving environment. Another reason for the user feeling insecure about activating a certain functionality of the vehicle while driving may be that the user is not sure how the vehicle will react in terms of driving behavior when the respective functionality is activated for the first time while driving. This may particularly be the case with advanced driver assistance functionalities. Altogether, an in-efficient and/or in-effective use of the functionalities of the vehicle leads to an in-efficient and/or in-effective operation of the vehicle. This means that the vehicle is operated in an inadequate manner, when considered alone. The same is true when the vehicle is regarded as an element of a traffic system.

### SUMMARY

It is therefore an objective of the present disclosure to eliminate or at least reduce in-efficient and/or in-effective operations of a vehicle.

The problem is at least partially solved or alleviated by the subject matter of the independent claims of the present disclosure, wherein further examples are incorporated in the dependent claims.

According to a first aspect, there is provided a method for providing a description of a functionality of a vehicle to a user of the vehicle. The method comprises:
- obtaining first data indicative of a current user behavior,
- obtaining second data indicative of a historic user behavior, wherein the historic user behavior is associated with the user located inside the vehicle while the vehicle is in a non-driving mode,
- determining a likelihood that the user will stay inside the vehicle while the vehicle is in the non-driving mode based on the first data and based on the second data, and
- triggering a provision of the description of the functionality of the vehicle, if said determined likelihood exceeds a predefined likelihood threshold.

Obtaining the first data indicative of the current user behavior is to be understood as receiving or determining the first data. The current user behavior describes from the perspective of the vehicle what the user is doing and where the user is located, i.e. activities of the user and a location of the user. The fact that the user behavior is a current user behavior means that the activities and locations of the user are related to a current drive cycle. This means that the user behavior happens just before a current drive cycle, during a current drive cycle or just after a current drive cycle. For example, the current user behavior describes the user approaching the vehicle, the user entering the vehicle, the user taking his or her seat in a driver's seat of the vehicle, the user waiting in the driver's seat of the vehicle while the vehicle is in a non-driving mode, the user leaving the vehicle and/or the user moving away from the vehicle. A case in which the user is waiting in the driver's seat of the vehicle may also be described as the user being located inside the vehicle while the vehicle is in a non-driving mode. According to further examples, the current user behavior may describe parking the vehicle or charging the vehicle. Further, the first data indicative of the current user behavior may comprise an information on a time, especially on a time of day and/or on a particular day of the week, of the above-mentioned activities and locations describing the current user behavior.

As already explained in conjunction with the first data, obtaining the second data indicative of the historic user behavior is to be understood as receiving or determining the second data. Similar to the current user behavior, the historic user behavior describes from the perspective of the vehicle what the user has been doing and where the user has been located, i.e. activities of the user and a location of the user. The fact that the user behavior is a historic user behavior means that the activities and locations of the user are from a past time. More precisely, the historic user behavior is related to a drive cycle that has been completed in a past time. In any case, the historic user behavior relates to a time prior to the current user behavior. For example, the historic user behavior describes the user approaching the vehicle, the user entering the vehicle, the user taking his or her seat in a driver's seat of the vehicle, the user waiting in the driver's seat of the vehicle while the vehicle is in a non-driving mode, the user leaving the vehicle and/or the user moving away from the vehicle. In particular, the historic user behavior may refer to a behavior that the user has shown repeatedly on a plurality of occasions. Like the first data, the second data indicative of the historic user behavior may comprise an information on a time, especially on a time of day and/or on a particular day of the week, of the historic user behavior.

The likelihood that the user will stay inside the vehicle while the vehicle is in the non-driving mode is determined based on the first data and based on the second data. This is understood in that the first data indicative of the current user behavior is compared to the second data indicative of the historic user behavior. As has been mentioned before, the second data relates to completed drive cycles dated from the past while the first data may relate to current drive cycle, i.e. to a user behavior just before the current drive cycle, to a user behavior during the current drive cycle or to a user behavior just after a current drive cycle. In this context, it is possible that a drive cycle has not yet been completed. Thus, if the comparison shows a high level of similarity of the first data and at least a portion of the second data, it is possible to predict or estimate a future user behavior in that it is assumed that the user will continue his or her behavior in the same manner as indicated by the second data. In simplified terms, if the first data corresponds or is similar to a first half of an item of the second data, one may predict that the user behavior in the near future will correspond or be similar to the second half of an item of the second data. Since practically, the first data and the second data will not be identical, this prediction whether the user will stay inside the vehicle while the vehicle is in the non-driving mode is expressed by a likelihood. This likelihood is high if the similarity between the first data and the second data is high. Accordingly, this likelihood is low if the similarity between the first data and the second data is low. If the determined likelihood exceeds a predefined likelihood threshold, the provision of the description of the functionality of the vehicle is triggered. In general, the functionality described, i.e. presented, demonstrated and/or explained, to the user may relate to any functionality of the vehicle. The method has the effect that the user of the vehicle is provided with the description of the functionality of the vehicle during a situation in which the user is likely to wait inside the vehicle while the vehicle is in the non-driving mode. In other words, the description of the functionality of the vehicle may be provided to the user when chances are high that the user has nothing else to do. Thus, the user is likely to be accessible for the description of the functionality of the vehicle. Consequently, the user is put in a position to be able to efficiently and effectively use the functionalities of the vehicle. Thus, the vehicle may be operated in a technically adequate manner. This applies when the vehicle is considered alone and when the vehicle is considered as an element of a traffic system. The effects of the present method become particularly clear when considering a functionality of the vehicle that has been used seldomly or not at all by the user. If, due to the provision of the description, the user is able to use this functionality, the vehicle may be operated more adequately.

It is noted that a mode in which a description of a functionality of the vehicle is provided to the user may be called a learning mode or a tutorial mode. Moreover, it is noted that the above-described method may come in addition to the possibility of manually triggering the provision of the description of the functionality of the vehicle by a user of the vehicle. This may be done in that the user manually activates the learning mode or tutorial mode in an entertainment system or information system of the vehicle.

In an example, the description of the functionality of the vehicle comprises a visual and/or acoustic description. The visual description is displayable on a screen of the vehicle. The acoustic description is transmittable by a speaker of the vehicle. The visual description may comprise a text, a picture, an animation and/or a video of how to activate and/or use the functionality of the vehicle. The screen of the vehicle may, for example, comprise a center stack display and/or a display behind the steering wheel that may also convey data on operational parameters of the vehicle to the user. The acoustic description transmittable by the speaker of the vehicle may comprise a language-based explanation and/or an onomatopoeic representation of the functionality of the vehicle. The visual and/or acoustic description may comprise an indication of which user interface element to actuate in order to activate and/or use the functionality of the vehicle. Moreover, the visual and/or acoustic description may comprise warning messages what to watch out for when activating and/or using the functionality of the vehicle. The visual and/or the acoustic description have the effect that the relevant description is efficiently and effectively provided to the user.

In an example, the description may comprise an induction into a basic vehicle functionality such as how to adjust a speed of windshield wipers or how to adjust a brightness threshold of an environment of the vehicle below which headlights of the vehicle shall automatically be activated. Teaching the user how to use basic vehicle functionalities in a standstill of the vehicle makes the user feel confident if the need for activating the basic functionality while driving. Thus, the vehicle may be operated more adequately.

In an example, the functionality of the vehicle comprises a driver assistance function. In other words, the description may describe how to use a driver assistance function. In an example, the driver assistance function may comprise at least one of a highway assist function, an assisted parking function, an assistance function on driving in reverse gear with a trailed hooked up to the vehicle and a lane keeping assistance function. In this context, a highway assist function allows the vehicle to be operated autonomously or partly autonomously when driving on a highway. Providing a description to the user how to use the driver assistance function in a standstill of the vehicle increases the likelihood that the user may apply the driver assistance function while driving the vehicle. This is because an entry barrier for a first and/or a confident use of the driver assistance function during a drive cycle is reduced for the user. Thus, the vehicle may be operated more adequately and/or more safely.

In an example, the description of the functionality of the vehicle comprises a simulation usable by the user. The simulation usable by the user is to be understood as a means for virtually testing of the functionality of the vehicle by the user while the vehicle is in a non-driving mode. This means that the user may be provided with a mocked activation response of the functionality of the vehicle. The mocked activation response may comprise at least one of a visual, acoustic, and haptic response. The visual response may be displayable on the screen of the vehicle. The acoustic response may be transmittable by the speaker of the vehicle. The haptic response may comprise a change in resistance of moveable components of the vehicle against actuation. For example, a clutch pedal, a brake pedal and/or an accelerator pedal may become more easily or harder depressible for the user than in a standard resistance configuration. Additionally or alternatively, the haptic response may comprise a vibration of a vibratable component of the vehicle, e.g. a steering wheel. Preferably, as mocked activation response of the functionality of the vehicle, the change in resistance and/or the vibration may be provided in different intensities. The term "mocked" refers to the fact that the response of the simulation of the functionality of the vehicle provided to the user does not originate from an actual activation of the functionality of the vehicle. Instead, the mocked activation response is to be understood as an artificially created response as if the respective functionality of the vehicle were actually activated. This creates a particularly realistic impression for the user of the vehicle of how the vehicle will actually react when the respective functionality is activated while driving.

In an example, the method further comprises:
- obtaining third data indicative of a manipulation of a control of the vehicle by the user, and
- adapting the simulation based on the third data.

Obtaining the third data indicative of the manipulation of the control of the vehicle is to be understood as receiving or determining the third data. The manipulation of the control of the vehicle may comprise user inputs to a user interface of the vehicle, e.g. in a cockpit. The user interface may comprise the steering wheel, the clutch pedal, the brake pedal, the accelerator pedal, switches, e.g. switches for activating the headlights of the vehicle, stalks, e.g. the stalk for activating the windshield wiper, and the like. Thus, the manipulation of a control of the vehicle may comprise a steering input, a depression of the clutch pedal, a depression of the brake pedal, a depression of the accelerator pedal, as well as actuation of switches and/or stalks and the like. Thus, the user can manipulate the simulation using the same user interface that is used for driving the vehicle. It is to be noted that a physical connection between the controls of the cockpit user interface and the respective physical actuators of the vehicle, which are usually activated when the controls of the user interface are manipulated, is interrupted during the simulation. A prerequisite for interrupting the physical connection between the controls of the user interface and the respective physical actuators of the vehicle is a fully electronic control of the physical actuators of the vehicle. A fully electronic control of the physical actuators of the vehicle may for example comprise a steer-by-wire system, an electronic clutch pedal, an electronic brake pedal and/or an electronic gas pedal. However, it is possible that visual feedback systems of the vehicle are used, e.g. in that indicator lights or graphics on a screen such as a driver information module are activated. Adapting the simulation based on the third data is to be understood in that the mocked response of the functionality of the vehicle provided to the user is adapted dynamically according to the user inputs. The visual response and/or the acoustic response may be adapted based on the user input. For instance, a virtual windscreen wiper of a virtual windscreen displayed on the screen of the vehicle may be shown to wipe the virtual windscreen once the user activates the stalk of the user interface for the actual, in the sense of real world, windshield wiper of the vehicle. The virtual display of the activated virtual windshield wiper may be accompanied by a sound that is played by the speaker of the vehicle that resembles the sound of the actual windshield wiper wiping the windshield. An example for adapting the haptic response of a control of the cockpit user interface may comprise changing a resistance towards turning of the steering wheel the further the user turns it to the left or to the right. It is to be understood that in the outlined example scenarios of adapting the simulation based on a manipulation of a control of the vehicle by the user, the actual windshield wiper of the vehicle is not activated and the steered wheels of the vehicle are not turned. This is because the physical connection between the controls of the cockpit user interface and the respective physical actuators of the vehicle is interrupted during the simulation. This has the effect that the user can safely try out different functionalities of the vehicle without having to worry about making mistakes in testing the respective functionality. This reduces an entry barrier for the user to make use of the functionality of the vehicle. Consequently, a likelihood that the user will make use of the functionality of the vehicle while driving is increased. Thus, the vehicle may be operated more adequately and/or more safely.

In an example, the simulation comprises a virtual driving environment. The virtual driving environment may comprise drivable roads, other traffic participants, a scenery and/or elements of urban infrastructure. A virtual representation of the vehicle may be able to drive around in the virtual driving environment. The virtual driving environment is displayable on the screen of the vehicle. Thus, the user can see how and where the virtual representation of the vehicle moves in the virtual driving environment. The user may adapt his or her manipulation of the controls of the vehicle in response to the movement of the virtual representation of the vehicle in the virtual driving environment. Since the simulation is adapted based on the user's manipulation of the controls of the vehicle, a driving response of the virtual representation of the vehicle in the virtual driving environment may in turn be adapted in response to the user's manipulation of the controls of the vehicle. In other words, the user may steer the virtual representation of the vehicle through the virtual driving environment as if he or she was playing a computer game or a videogame. The difference to a computer game or a videogame is that the user does not make game instructions via a mouse, a keypad or a game controller. Instead, the user provides his or her instructions to the virtual representation of the vehicle in the virtual driving environment through the real-world controls of the vehicle. This way, the user of the vehicle gets acquainted with operating the controls and the underlying functionalities of the real-world vehicle by trying them out in the virtual driving environment. This is particularly beneficial for teaching the user or describing to the user, how to use driver assistance functions of the vehicle because the user can safely experience a driving response of the virtual representation of the vehicle when a respective driver assistance function is activated and thus tested through simulation. Thus, the vehicle may be operated more adequately and/or more safely.

In an example, the virtual driving environment is at least partially based on a historic real world driving environment. The historic real world driving environment is to be understood as an actual driving environment in which the actual vehicle was driving in the past. The historic real world driving environment may be captured by environment detection sensors during driving of the actual vehicle within the real world driving environment. The historic real world driving environment may for example comprise the roads used and the scenery passed during a daily commute of the user that the user covers using the vehicle. This means that the virtual driving environment comprises similarities to the historic real world driving environment. For example, the roads that the virtual representation of the vehicle takes in the virtual driving environment may correspond to the roads that the actual vehicle took during covering of the daily commute of the user. The corresponding roads may be accompanied by similar surroundings, the same succession of turns and/or by a similar level of traffic volume occurring on the roads. By providing the simulation based on a historic real world driving environment, the user feels directly addressed by the simulation because he or she will recognize the historic real world driving environment in the virtual driving environment. This increases a learning success of the user. Moreover, particularly when the functionality of the vehicle to be learned by the user comprises a sophisticated driver assistance function, the user of the vehicle feels more confident in case of actually activating the respective driver assistance function when he or she drives in the historic real world driving environment again. Thus, the vehicle may be operated more adequately and/or more safely.

In an example, the virtual driving environment is separate from a real world driving environment. This may particularly be useful when a particular functionality of the vehicle would not be available in a historic real word driving environment. For example, the vehicle may have never actually towed a trailer. When triggering the description of a driver assistance function that assists the user in driving in reverse with the trailer hooked up to the vehicle, the virtual representation of the vehicle pushes a virtual representation of the trailer backwards in a virtual driving environment that is not based on a historic real world driving environment. Also, the virtual driving environment does not need to correspond to any real world driving environment. Instead, the virtual driving environment may be a fantasy driving environment, i.e. a purely artificial driving environment, that may be well-suited for presenting, demonstrating and/or explaining a particular functionality of the vehicle to the user. The virtual driving environment being separate from a real-world driving environment may mean that the virtual driving environment is less complex than a real world driving environment. This reduces a potential distraction of the user from a presentation, demonstration and/or explanation of the functionality of the vehicle by the virtual driving environment. In other words, a focus of the user on the presentation, demonstration and/or explanation of the functionality of the vehicle in the learning mode is enhanced.

In an example, determining a likelihood that the user will stay inside the vehicle while the vehicle is in the non-driving mode comprises extrapolating the first data and/or assessing at least one similarity between the first data and the second data. An extrapolation of the first data may be understood as generating a prediction of how the first data may developed in a future point in time or period of time. For example, the first data may be indicative of the user approaching the vehicle. It may be inferred that the user will be located inside the vehicle in a subsequent point in time because is it usually the case that, after having approached the vehicle, the user will open a door of the vehicle and take his or her seat inside the vehicle. Thus, the determination of the likelihood that the user will stay inside the vehicle while the vehicle is in the non-driving mode may be initiated at an earlier point in time than when the first data indicates that the user is actually located inside the vehicle. This comes with the advantage that a possibly complex simulation of a functionality of the vehicle may already be computationally fully loaded when the user is located inside the vehicle. Thus, the provision of the description of the functionality of the vehicle can immediately be triggered. This may directly arise an interest of the user as soon as he or she is actually located inside the vehicle before he or she begins checking other things, e.g. his or her smartphone or his or her hairstyle in a rearview mirror of the vehicle. This increases the likelihood that the user of the vehicle actually starts using the description of the functionality of the vehicle. A similarity between the first data and the second data may not only refer to the actual user behavior but also to circumstances in which the user exhibits the user behavior. Such circumstances may relate to a time of day, a day of the week and/or a location of the user behavior. Thus, when the historic user behavior and the current user behavior are shown under similar circumstances, the likelihood that the user will stay inside the vehicle while the vehicle is in the non-driving mode may be determined to be particularly high. Thus, assessing at least one similarity between the first data at the second data improves a determination accuracy of the likelihood that the users will stay inside the vehicle while the vehicle is in the non-driving mode.

In an example, the method further comprises adjusting the predefined likelihood threshold based on a user reaction to the provision of the description of the functionality of the vehicle. Upon triggering the provision of the description on the functionality of the vehicle, the user may actively accept and/or start using the description. However, the user may also actively decline the description. Moreover, a user may passively ignore or simply not use the description. The outlined scenarios all are examples of a user reaction to the provision of the description. Adjusting the predefined likelihood threshold based on the user reaction means that the provision of the description may be triggered at a different likelihood threshold depending on a previous user reaction to the learning mode. For example, if the user has declined, ignored or not noticed the description on the functionality of the vehicle at a given level of determined likelihood, the likelihood threshold that the provision of the description on the respective functionality of the vehicle shall be triggered may be increased for the next time. Moreover, if the user has accepted the description on the functionality of the vehicle at another given level of determined likelihood, the likelihood threshold that the provision of the description on the respective functionality of the vehicle shall be triggered may be decreased for the next time. This ensures that the provision of the description is only triggered when the user of the vehicle is actually likely to use the description. As an effect, the user of the vehicle keeps paying attention to triggerings of the provision of the description and does not ignore such triggerings completely after a certain period of usage of the vehicle.

In an example, the method is executed after the vehicle has performed a parking maneuver or during a charging procedure or before the start of a drive cycle. When the vehicle has performed a parking maneuver, the vehicle is in the non-driving mode. Moreover, when the vehicle has performed a parking maneuver, chances are particularly high that the user will stay inside the vehicle because he or she may wait for another person to meet. Similarly, when the vehicle, more precisely, a traction battery of the vehicle, is being charged at a charging station, the vehicle is obviously in the non-driving mode. Since the charging procedure usually takes a significant period of time, chances are also high that the user will stay inside the vehicle. Before the start of a drive cycle, the vehicle is also in the non-driving mode. Also in this occasion, chances are particularly high that the user will stay inside the vehicle before he or she actually starts driving. Thus, in the outlined occasions, it is particularly likely that a determined likelihood that the user will stay inside the vehicle while the vehicle is in the non-driving mode will surpass the predefined likelihood threshold. This means that the user of the vehicle may be particularly open to use the description of the functionality of the vehicle.

According to a second aspect, there is provided a data processing apparatus comprising means for carrying out the method of the first aspect. Using such a data processing apparatus, a description of a functionality of a vehicle may be provided to a user of the vehicle in a reliable manner. This has the effect that the user of the vehicle is provided with the description by the data processing apparatus at occasions in which the user is likely to wait inside the vehicle while the vehicle is in the non-driving mode. In other words, the description may be provided to the user when chances are high that the user has nothing else to do. Thus, the user is likely to be free to use the description of the functionality of the vehicle. This enhances a knowledge of the user of functionalities of his or her vehicle. If, due to the provision of the description, the user is able to use this functionality, the vehicle may be operated more adequately.

According to a third aspect, there is provided a computer program comprising instructions which, when the computer program is executed by a computer, cause the computer to carry out the method of the first aspect. Using such a computer program, a description of a functionality of a vehicle may be provided to a user of the vehicle in a reliable manner. This has the effect that the user of the vehicle is provided with the description of the functionality of the vehicle at occasions in which the user is likely to wait inside the vehicle while the vehicle is in the non-driving mode. In other words, the description may be provided to the user when chances are high that the user has nothing else to do. Thus, the user is likely to be free to use the description of the functionality of the vehicle. This enhances a knowledge of the user of functionalities of his or her vehicle. If, due to the provision of the description, the user is able to use this functionality, the vehicle may be operated more adequately.

According to a fourth aspect, there is provided a computer-readable storage medium comprising instructions which, when executed by a computer, cause the computer to carry out the method the first aspect. Using such a computer-readable storage medium, a description of a functionality of a vehicle may be provided to a user of the vehicle in a reliable manner. This has the effect that the user of the vehicle is provided with the description of the functionality of the vehicle at occasions in which the user is likely to wait inside the vehicle while the vehicle is in the non-driving mode. In other words, the description may be provided to the user when chances are high that the user has nothing else to do. Thus, the user is likely to be free to use the description of the functionality of the vehicle. This enhances a knowledge of the user of functionalities of his or her vehicle. If, due to the provision of the description, the user is able to use this functionality, the vehicle may be operated more adequately.

According to a fifth aspect, there is provided a vehicle comprising a data processing apparatus according to the second aspect. Providing such a vehicle, a description of a functionality of a vehicle may be provided to a user of the vehicle in a reliable manner. This has the effect that the user of the vehicle is provided with the description by the vehicle at occasions in which the user is likely to wait inside the vehicle while the vehicle is in the non-driving mode. In other words, the description may be provided to the user when chances are high that the user has nothing else to do. Thus, the user is likely to be free to use the description of the functionality of the vehicle. This enhances a knowledge of the user of functionalities of his or her vehicle. If, due to the provision of the description, the user is able to use this functionality, the vehicle may be operated more adequately.

The method of the present disclosure may be at least partly computer-implemented, and may be implemented in software or in hardware, or in software and hardware. Further, the method may be carried out by computer program instructions running on means that provide data processing functions. The data processing means may be a suitable computing means, such as an electronic control module etc., which may also be a distributed computer system. The data processing means or the computer, respectively, may comprise one or more of a processor, a memory, a data interface, or the like.

It should be noted that the above examples may be combined with each other irrespective of the aspect involved.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a vehicle according to the present disclosure comprising a data processing apparatus according to the present disclosure comprising means for carrying out the method according to the present disclosure for providing a description of a functionality of the vehicle to a user of the vehicle,
- Figure 2: shows a cockpit of the vehicle of Figure 1 comprising a screen on which a driving simulation is displayed that has been triggered by the method according to the present disclosure,
- Figure 3: schematically shows the vehicle of Figure 1 being located at a home of the user of the vehicle,
- Figure 4: schematically shows the vehicle of Figure 1 being located at a school of a child of the user of the vehicle,
- Figure 5: schematically shows the vehicle of Figure 1 being located at a charging station where a traction battery of the vehicle is being charged, and
- Figure 6: illustrates steps of the method according to the present disclosure for providing a description of a functionality of the vehicle to the user of the vehicle.

### DETAILED DESCRIPTION

The Figures are merely schematic representations and serve only to illustrate examples of the disclosure. Identical or equivalent elements are in principle provided with the same reference signs.

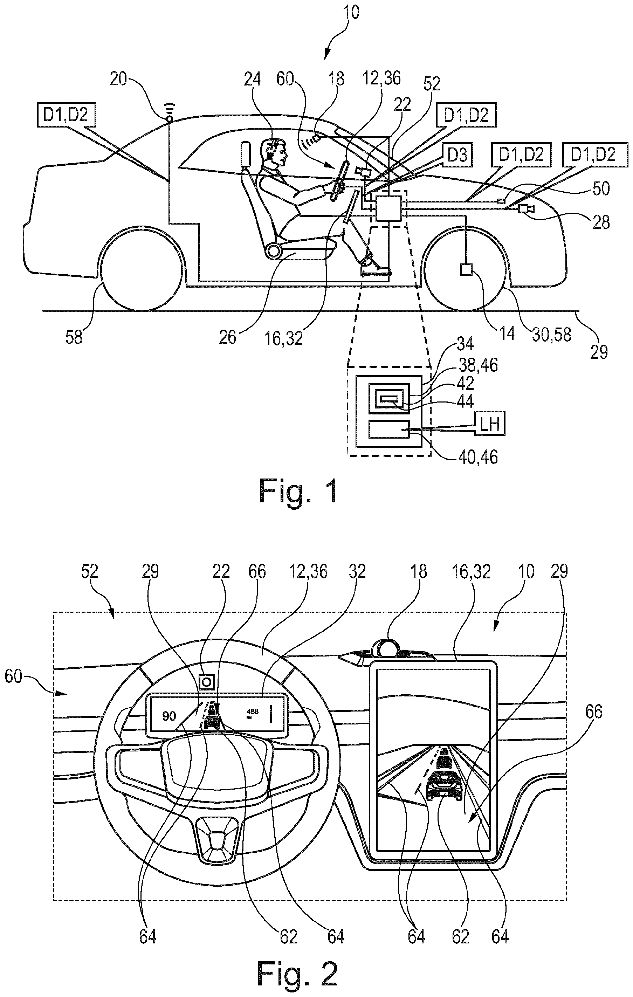

Figure 1 shows a vehicle 10.

The vehicle 10 comprises a steering wheel 12, a steering actuator 14, a center stack display 16, a speaker 18 and a global positioning system (GPS) antenna 20.

The vehicle 10 further comprises a first camera 22 configured to capture a view of the interior of the vehicle 10. In particular, the first camera 22 may capture a view of a user 24 of the vehicle 10 being located inside the vehicle 10. The data provided by the first camera 22 may particularly be indicative of the user 24 entering the vehicle 10, the user 24 sitting on a driver's seat 26 of the vehicle 10 and/or the user 24 exiting the vehicle 10. Thus, the first camera 22 is configured to provide data indicative of a user behavior.

The data provided by the first camera 22 may comprise first data D1 indicative of a current user behavior. The current user behavior refers to a point in time at which a method for providing a description of a functionality of the vehicle 10 to the user 24 of the vehicle 10 is executed. Moreover, the current user behavior is associated with a current drive cycle.

The data provided by the first camera 22 may also comprise second data D2 indicative of a historic user behavior. The historic user behavior refers to a point in time prior to an execution of the method for providing a description of a functionality of the vehicle 10 to the user 24 of the vehicle 10. This means that the historic user behavior is associated with a historic drive cycle, i.e. a drive cycle from a past time.

It is noted that, even though just one first camera 22 is shown in the Figures, the vehicle 10 may comprise two or more first cameras. In the latter case, the first camera 22 shown in the Figures may be considered to be representative of the two or more first cameras.

Moreover, the vehicle 10 comprises a second camera 28 configured to capture a view of an environment of the vehicle 10. In particular, the second camera 28 may capture a view comprising the user 24 of the vehicle 10 approaching the vehicle 10 or departing from the vehicle 10. Thus, also the second camera 28 is configured to provide data indicative of a user behavior.

Like the data provided by the first camera 22, the data provided by the second camera 28 may comprise first data D 1 indicative of a current user behavior and second data D2 indicative of a historic user behavior.

Moreover, the second camera 28 may capture a view of a driving environment of the vehicle 10. The view of the driving environment may comprise a view of a road 29 on which the vehicle 10 is traveling, a view of other traffic participants 62 and/or a view of the scenery in which the vehicle 10 is located.

It is noted that, even though just one second camera 28 is shown in the Figures, the vehicle 10 may comprise two or more second cameras. In the latter case, the second camera 28 shown in the Figures may be considered to be representative of the two or more second cameras.

The steering wheel 12 is configured to be operated by the user 24, i.e. to receive manipulation instructions of the user 24 for controlling, i.e. steering, the vehicle 10.

Third data D3 indicative of the manipulation instructions of the user 24 for controlling the vehicle 10 is transmitted to the steering actuator 14, which is configured to turn front wheels 30 of the vehicle 10 based on the third data D3 in order to let the vehicle 10 make turns.

The center stack display 16 is a screen 32 that is able to provide visual information to the user 24 of the vehicle 10.

The vehicle 10 also comprises a further screen 32 that is located behind the steering wheel 12 and that is also able to provide visual information to the user 24 of the vehicle 10 (see Figure 2). It is noted that in other examples, the screen 32 may alternatively be located above the steering wheel 12 or on the steering wheel 12. Further alternatively, the screen 32 may be replaced by a head-up display, i.e. a projection in the windshield in front of the user 24 of the vehicle 10.

As a means for providing acoustic information to the user 24 of the vehicle 10, the vehicle 10 comprises the speaker 18.

The GPS antenna 20 is configured to provide location data of the vehicle 10. In connection with data from the first camera 22 and/or data from the second camera 28, the location data may form part of the first data D1 and/or of the second data D2. In other words, the first data D1 and/or the second data D2 may comprise an information on a location at which the user 24 exhibits a current user behavior and/or exhibited a historic user behavior.

Furthermore, the vehicle 10 comprises a data processing apparatus 34. The steering wheel 12, the steering actuator 14, the center stack display 16, the speaker 18, the GPS antenna 20, the first camera 22 and the second camera 28 are communicatively connected to the data processing apparatus 34.

It is to be understood that the data processing apparatus 34 being arranged in the connection line between the steering wheel 12 and the steering actuator 14 comes in addition to the above-outlined usual steering functionality of the steering wheel 12 and the steering actuator 14.

Thus, the data processing apparatus 34 may be provided with first data D1 indicative of a current user behavior.

The data processing apparatus 34 may also be provided with second data D2 indicative of a historic user behavior.

The data processing apparatus 34 may additionally be provided with third data D3 indicative of a manipulation of a control 36, i.e. of the steering wheel 12, of the vehicle 10 by the user 24.

Beyond that, the data processing apparatus 34 may be provided with data indicative of a driving environment of the vehicle 10.

The data processing apparatus 34 comprises a data storage unit 38 and a data processing unit 40.

The data storage unit 38 comprises a computer-readable storage medium 42.

On the computer-readable storage medium 42, there is provided a computer program 44.

The computer program 44 and, thus, also the computer-readable storage medium 42, comprise instructions which, when executed by the data processing unit 40, or, more generally speaking, a computer, cause the computer or the data processing unit 40 to carry out the method for providing a description of a functionality of the vehicle 10 to the user 24 of the vehicle 10.

Consequently, the data storage unit 38 and the data processing unit 40 form means 46 for carrying out the method for providing a description of a functionality of the vehicle 10 to the user 24 of the vehicle 10.

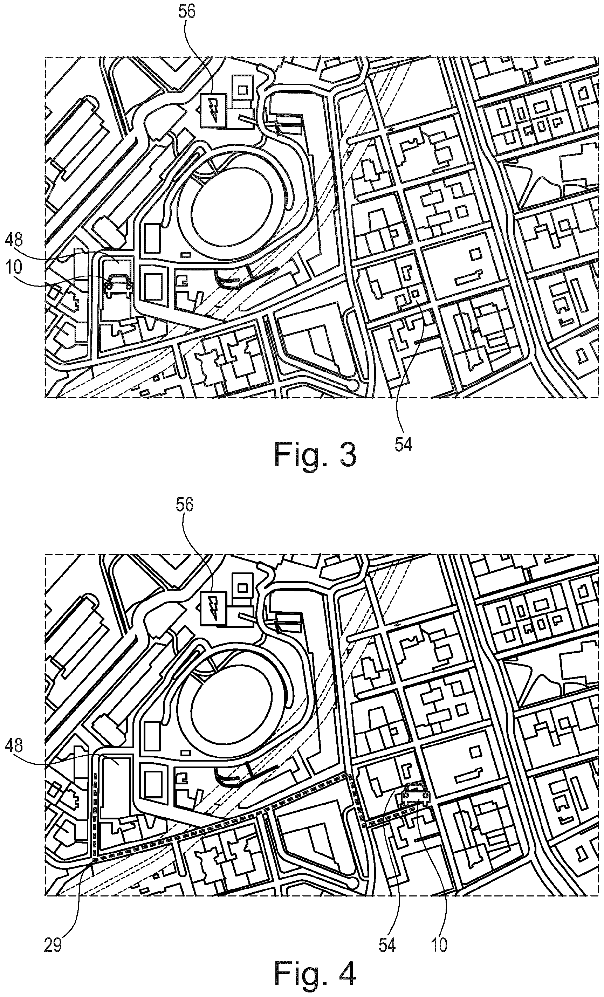

In the following, this method will be explained in more detail in connection with driving scenarios as illustrated in Figures 3 to 5.

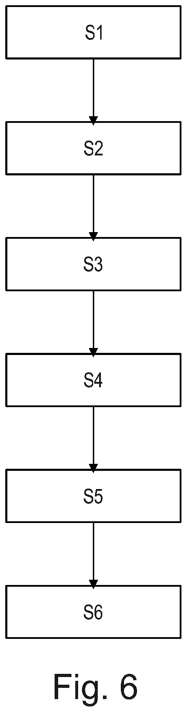

An illustration of steps of the method for providing a description of a functionality of the vehicle 10 to the user 24 of the vehicle 10 is shown in Figure 6.

Figure 3 illustrates a first driving scenario. In this scenario, the user 24 of the vehicle 10 waits inside the vehicle 10 without starting to drive because a windshield 52 of the vehicle 10 needs to be defrosted prior to starting the drive cycle.

In more detail, in step S1 of the method, first data D 1 indicative of the current user behavior is obtained.

As first data D 1 in the first driving scenario, the second camera 28 detects that the user 24 is approaching the vehicle 10. The first camera 22 detects that the user 24 is taking his or her seat in the driver's seat 26 of the vehicle 10. The GPS signal from the GPS antenna 20 indicates that the vehicle 10 is located at the home 48 of the user 24 of the vehicle 10. The environmental thermometer 50 of the vehicle 10 detects an environmental temperature of - 5°C.

In step S2 of the method for providing the description, second data D2 indicative of a historic user behavior is obtained. The historic user behavior comprises situations in which the user 24 is located inside the vehicle 10 while the vehicle 10 is in a non-driving mode.

In the example shown, the second data D2 is stored on the data storage unit 38. Thus, in the step S2, the second data needs to be looked up from the data storage unit 38.

It is understood that the second data D2 comprises a plurality of data items or data sets relating to different historic situations, i.e. to different historic user behavior which may be associated with different historic situations.

At least one data item or data set of the second data D2 is based on a historic situation in which the first camera 22 has detected the user 24 taking his or her seat in the driver's seat 26 and remaining inside the vehicle 10 without starting to drive.

Also in this historic situation, the GPS antenna 20 has provided data indicative of the vehicle 10 being located at a home 48 of the user 24 of the vehicle 10.

Still in this historic situation, an environmental thermometer 50 of the vehicle 10 has detected an environmental temperature of the vehicle 10 of 0°C.

Other parts of the second data D2, particularly parts indicative of the non-driving mode, have been obtained from a motor, a gearbox, a road wheel 58 and/or from the drive lever unit of the vehicle 10 (not shown).

Still other parts of the second data D2 have been obtained from the GPS antenna 20, the environmental thermometer 50 of the vehicle 10, the internal clock, the internal calendar and/or the charging unit of the vehicle 10.

The stored second data D2 is aggregated by the data processing unit 40 of the data processing apparatus 34 to the historic user behavior by determining patterns in the stored second data D2 that become evident over time. In other words, the data processing unit 40 of the data processing apparatus 34 may recognize repetitions in the stored second data D2 over time and derive habits of the user 24 of the vehicle 10 therefrom.

In the first scenario, the second data D2 indicative of the historic user behavior describes the habit that the user 24 usually waits inside the vehicle 10 without starting to drive if an environmental temperature of the vehicle 10 is 0°C or less in order to defrost the windshield 52 of the vehicle 10.

In step S3 of the method for providing the description, the first data D1 indicative of the current user behavior is compared to the second data D2 indicative of the historic user behavior. A likelihood LH that the user will stay inside the vehicle 10 while the vehicle 10 is in the non-driving mode is determined depending on the level of similarity between the first data D1 and the second data D2.

With respect to the first scenario, it can be noted that the user 24 of the vehicle 10 remains inside the vehicle 10 while the vehicle 10 is located at the user's home 48 and an environmental temperature of the vehicle 10 is -5°C. Thus, from comparison to the historic user behavior, it can be inferred that the user 24 has to defrost the windshield 52 of the vehicle 10 before being able to start a drive cycle.

In summary, it is determined by the data processing apparatus 34 that the user 24 of the vehicle 10 is likely to remain inside the vehicle 10 while the vehicle 10 is in a non-driving mode for some time in all of the outlined three scenarios.

In step S4 of the method for providing the learning mode, the determined likelihood LH is compared to a predefined likelihood threshold.

If the determined likelihood LH is above the predefined likelihood threshold, the provision of the description of the functionality of the vehicle 10 is triggered. This means that the user 24 of the vehicle 10 is confronted with a prompt on the center stack display 16 to use such a description. More generally speaking, the user 24 may be prompted to start a learning mode of the vehicle 10.

The user 24 reacts to the triggering of the provision of the description.

On the one hand, the user 24 may decline the use of the description. Alternatively, the user 24 may ignore the prompt on the center stack display 16 or the user 24 may simply not become aware of the prompt on the center stack display 16. In these cases, the predefined likelihood threshold may be adjusted to a higher value for a next execution cycle of the method. This is done in a step S5 of the method. This way, the determined likelihood LH that the user will stay inside the vehicle 10 needs to be even higher the next time such that the method triggers the provision of the description. The adjustment of the predefined likelihood threshold to a higher value ensures that the description is only triggered when there is a high chance that the user 24 is actually interested in using the description.

If the user 24 declines the use of the description or does not start using the description within a predefined period of time, e.g. 1 minute, the method is abandoned.

On the other hand, the user 24 may accept starting to use the description. In this case, the likelihood threshold may be adjusted to a lower value for a next execution cycle of the method. This may be done in the step S5. This way, the determined likelihood LH that the user will stay inside the vehicle 10 does not need to be as high the next time the method is executed in order to trigger the provision of the description. The adjustment of the predefined likelihood threshold to a lower value ensures that the user 24 is prompted with the provision of the description as often as possible if the user 24 regularly accepts to start using the description.

The description can have different forms which will be explained in the following as a number of examples.

In a first example, the description comprises an introduction on how to activate the rear window heating of the vehicle 10.

On the center stack display 16, there may be provided a visual tutorial describing where the switch for activating the rear window heating can be found in a cockpit 60 of the vehicle 10. The visual tutorial may be accompanied by an acoustic explanation that is provided via the speaker 18 arranged in the interior of the vehicle 10.

In a second example, the learning mode comprises an introduction into a lane keeping assistance function of the vehicle 10.

To further improve a learning effect of the user 24 in this second example, the description may comprise a simulation.

In this context, the user 24 may be prompted to select between a random driving environment or a representation of the user's daily commute to work as a driving environment for the simulation.

The random driving environment may be a pre-programmed driving environment that is not based on any real world driving environment.

A representation of the user's daily commute to work may be a virtual driving environment that is rendered based on data captured by the second camera 28 during the user's 24 daily commute to work. The representation of the user's daily commute to work is stored on the data storage unit 38 of the data processing apparatus 34. Optionally, also data captured by a radar unit or a lidar unit may be used as a basis for rending the virtual driving environment.

Among the plurality of routes that the vehicle 10 may have taken, the user's 24 daily commute to work may be identified based on GPS location data and based on the fact that the user 24 usually completes the route of his or her daily commute to work every workday.

The user 24 may select the representation of the daily commute as the virtual driving environment for the driving simulation.

Thus, the representation of the user's 24 daily commute is displayed as a driving environment on the center stack display 16. Additionally or alternatively, the representation of the user's 24 daily commute may be displayed as a driving environment on a display behind the steering wheel 12 that provides additional data on a virtual driving state, e.g. virtual speed and virtual remaining capacity of the traction battery, of the virtual representation of the vehicle 10 during the driving simulation (see also Figure 2).

The virtual driving environment may additionally comprise a representation of a landscape and/or a scenery through which the user's 24 daily commute leads. Moreover, the virtual driving environment may comprise a representation of roads 29 that the user 24 takes on his or her daily commute. Furthermore, the virtual driving environment may comprise a representation of other traffic participants 62 that use the same roads 29 as the virtual representation of the vehicle 10.

Traffic noise from the virtual driving environment may be provided to the user 24 by the speaker 18 in the interior of the vehicle 10.

The visual and the acoustic representation of the user's 24 daily commute creates a realistic impression of a real world driving scenario for the user 24.

When using the simulation, the user can use the lane keeping assistance, thereby creating experience and confidence in this functionality of the vehicle.

By learning about the lane keeping assistance function in a realistic driving simulation, the user 24 is particularly likely to use the lane keeping assistance function on his or her real-world daily commute to work in the future.

In step S6 of the method for providing the learning mode, the user 24 steers the virtual representation of the vehicle 10 through the virtual driving environment displayed on the center stack display 16 and/or on the display behind the steering wheel 12 through steering instructions to the actual, in the sense of real world, steering wheel 12 of the vehicle 10.

This means that the virtual representation of the vehicle 10 in the driving simulation changes its course based on the steering instructions provided through the actual steering wheel 12 of the vehicle 10.

More generally speaking, third data D3 indicative of a manipulation of a control 36 of the vehicle 10, in the present example the steering wheel 12, is obtained, e.g. received by the data processing unit 40. Based on this third data D3, the simulation is adapted, more precisely, the virtual representation of the vehicle is steered through the virtual driving environment.

A prerequisite for this is of course that the vehicle 10 comprises a steer-by-wire system. This means that the data processing apparatus 34 interrupts a connection between the steering wheel 12 and the steering actuator 14 during the driving simulation. As a consequence thereof, the front wheels 30 of the vehicle 10 will not turn when the user 24 of the vehicle 10 turns the steering wheel 12 during the simulation.

Of course, the same also applies for the clutch pedal, the brake pedal, the gas pedal and other switches as well as stalks in the cockpit 60 of the vehicle 10. This means that in the simulation mode, the data processing apparatus 34 also interrupts a connection between these pedals, switches, stalks and actual physical actuators of the vehicle 10 normally connected to said pedals, switches and stalks in a driving mode of the vehicle 10.

Coming back to the driving simulation, if the virtual vehicle 10 comes too close to or crosses lane markings 64 of a virtual representation of a road 29 without the user 24 having set a turn indicator, which the user 24 can do by actuating the actual, in the sense of real-world, turn indicator of the vehicle 10, the behavior of the lane keeping assistance function is replicated by vibrating the steering wheel 12. Due to this, the user 24 knows that he or she has come close to departing or has even departed from the intended lane 66 of the virtual representation of the road 29 with the virtual vehicle 10.

As soon as the user 24 steers the virtual vehicle 10 back to the center of the intended lane 66 by means of an instruction via the actual steering wheel 12 of the vehicle 10, the vibration of the actual steering wheel 12 of the vehicle 10 stops.

Additionally, it is to be noted that the steering wheel 12 is not entirely free to rotate during the simulation. A self-aligning torque setting the steering wheel 12 back to a neutral position is applied to the steering wheel 12 by a motor to artificially recreate the self-aligning torque during actual driving of the vehicle 10. The self-aligning torque depends on an extent of a turn to a left or to a right from a neutral position of the steering wheel 12. In this context, the neutral position of the steering wheel 12 is to be understood as a position in which the vehicle 10 drives along a straight trajectory.

This way, the user 24 is provided with a driving response of the virtual vehicle 10 in the simulation that is as close as possible to the actual, real world driving response of the vehicle 10. Thus, the user 24 feels confident and is not surprised about the actual driving response of the vehicle 10 when he or she activates the lane keeping assistance function in an actual drive cycle.

Figure 4 illustrates a second driving scenario. In the following, only the differences with respect to the first driving scenario will be explained.

In the second driving scenario, the user 24 of the vehicle 10 waits inside the vehicle 10 while the vehicle 10 is parked. This is due to the fact that the user 24 of the vehicle 10 is waiting to pick up his child from school 54.

Thus, as first data D 1 in the second scenario, the first camera 22 detects that the user 24 remains inside the vehicle 10. The GPS signal from the GPS antenna 20 indicates that the vehicle 10 has driven from the home 48 of the user 24 to the school 54 of the user's child. From a position of the drive lever of the drive lever unit, it is indicated to the data processing apparatus 34 that the vehicle 10 is in the parking mode. The internal calendar and the internal clock of the vehicle 10 indicate that it is a Wednesday, 12:50 pm.

As before, the obtained second data D2 is indicative of a historic user behavior.

The historic user behavior comprises situations in which the user 24 is located inside the vehicle 10 while the vehicle 10 is in a non-driving mode.

In the example shown, the second data D2 is stored on the data storage unit 38. Thus, in the step S2, the second data needs to be looked up from the data storage unit 38.

It is understood that the second data D2 comprises a plurality of data items or data sets relating to different historic situations, i.e. to different historic user behavior which may be associated with different historic situations.

At least one data item or data set of the second data D2 is based on a historic situation in which the first camera 22 has detected the user 24 remaining inside the vehicle 10.

The GPS antenna 20 has provided data indicative of the vehicle 10 being located at a school 54 of the user's child. Moreover, a drive lever unit of the vehicle 10 has provided data indicative of the vehicle 10 being in a parking mode. An internal calendar of the vehicle 10 has provided data indicative of a day of the week, which is, in the present example of the second scenario, a Wednesday. An internal clock of the vehicle 10 has provided data indicative of a time of day, which is, in the present example of the second scenario, 1 pm.

With respect to the second scenario, it can be noted that the user 24 of the vehicle 10 has driven to his child's school 54 on a Wednesday. Although the user 24 usually picks his child up at 1 pm, it can be inferred that the user 24, having already arrived at the school 54 at 12:50 pm, is simply too early. In other words, the current user behavior can be extrapolated in that the user 24 will be picking up his child at the school 54 in 10 minutes time. Thus, from comparison of the extrapolated first data D1 to the historic user behavior, it can be inferred that the user 24 of the vehicle 10 will remain inside the vehicle 10 for another 10 minutes.

Consequently, the provision of a description of a functionality of the vehicle is triggered. In this context, the description may relate to the same functionalities that have already been explained in detail in connection with the first driving scenario.

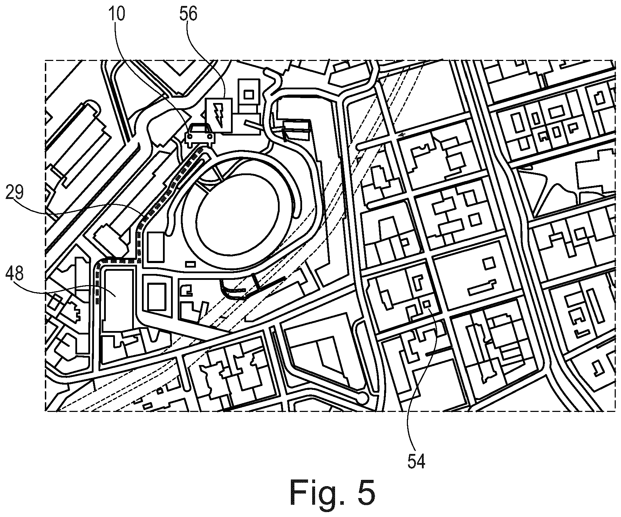

Figure 5 illustrates a third driving scenario. In the following, only the differences with respect to the first driving scenario and the second driving scenario will be explained.

In the third driving scenario, the user 24 of the vehicle 10 waits inside the vehicle 10 while the traction battery of the vehicle 10 is being charged. This is due to the fact that the user 24 is expecting the charging process to be completed soon. This is due to the fact that the traction battery is being charged at a charging power of 100 kW, which indicates fast charging and therefore a completion of the charging process in a timely manner.

Thus, as first data D1 in the third scenario, the first camera 22 detects the user remaining inside the vehicle 10.

Moreover, also as part of the first data D1, The GPS antenna 20 provides data indicative of the vehicle 10 being located at a charging station 56.

Additionally, also as part of the first data, a charging unit of the vehicle 10 provides data indicative of an active charging process of a traction battery of the vehicle 10. The data indicative of the active charging process shows that the traction battery of the vehicle 10 is being charged at a charging power of 150 kW.

As before, the obtained second data D2 is indicative of a historic user behavior.

The historic user behavior comprises situations in which the user 24 is located inside the vehicle 10 while the vehicle 10 is in a non-driving mode.

In the example shown, the second data D2 is stored on the data storage unit 38. Thus, in the step S2, the second data needs to be looked up from the data storage unit 38.

It is understood that the second data D2 comprises a plurality of data items or data sets relating to different historic situations, i.e. to different historic user behavior which may be associated with different historic situations.

At least one data item or data set of the second data D2 is based on a historic situation in which the first camera 22 has detected the user 24 remaining inside the vehicle 10.

The GPS antenna 20 has provided data indicative of the vehicle 10 being located at a charging station 56. An internal clock of the vehicle 10 has provided data indicative of a historic charging time of 20 minutes.

Thus, in the third scenario, the second data D2 indicative of the historic user behavior describes the habit that the user 24 usually waits inside the vehicle 10 while charging the traction battery of the vehicle 10 at a charging power of 100 kW (fast charging) or above (super-fast charging).

With respect to the third scenario, it can be noted that the user 24 of the vehicle 10 has driven to a charging station 56. Since the traction battery of the vehicle 10 is being charged there at a charging power of 150 kW, it can be inferred that the charging will not take too long and the user 24 of the vehicle 10 will remain inside the vehicle 10 until completion of the charging process.

Consequently, the provision of a description of a functionality of the vehicle is triggered. In this context, the description may relate to the same functionalities that have already been explained in detail in connection with the first driving scenario.

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. A computer program may be stored/distributed on a suitable medium such as an optical storage medium or a solid-state medium supplied together with or as part of other hardware, but may also be distributed in other forms, such as via the Internet or other wired or wireless telecommunication systems. Any reference signs in the claims should not be construed as limiting the scope of the claims.

### LIST OF REFERENCE SIGNS

- 10: vehicle
- 12: steering wheel
- 14: steering actuator
- 16: center stack display
- 18: speaker
- 20: GPS antenna
- 22: first camera
- 24: user
- 26: driver's seat
- 28: second camera
- 29: road
- 30: front wheel
- 32: screen
- 34: data processing apparatus
- 36: control of the vehicle
- 38: data storage unit
- 40: data processing unit
- 42: computer-readable storage medium
- 44: computer program
- 46: means for carrying out method for providing a learning mode
- 48: home of user
- 50: environmental thermometer
- 52: windshield
- 54: school
- 56: charging station
- 58: road wheel
- 60: cockpit
- 62: other traffic participant
- 64: lane marking
- 66: lane

- D1: first data
- D2: second data
- D3: third data
- LH: likelihood that user will stay inside vehicle

## Claims

1. A method for providing a description of a functionality of a vehicle (10) to a user (24) of the vehicle (10), the method comprising:
- obtaining first data (D1) indicative of a current user behavior,
- obtaining second data (D2) indicative of a historic user behavior, wherein the historic user behavior is associated with the user (24) located inside the vehicle (10) while the vehicle (10) is in a non-driving mode,
- determining a likelihood (LH) that the user (24) will stay inside the vehicle (10) while the vehicle (10) is in the non-driving mode based on the first data (D1) and based on the second data (D2), and
- triggering a provision of the description of the functionality of the vehicle (10), if said determined likelihood (LH) exceeds a predefined likelihood threshold.

2. The method of claim 1, wherein the description of the functionality of the vehicle (10) comprises a visual and/or acoustic description displayable on a screen (32) of the vehicle (10) and/or transmittable by a speaker (18) of the vehicle (10).

3. The method of claim 1 or 2, wherein the functionality of the vehicle (10) comprises a driver assistance function.

4. The method according to any one of the preceding claims, wherein the description of the functionality of the vehicle (10) comprises a simulation usable by the user (24).

5. The method according to claim 4, further comprising:
- obtaining third data (D3) indicative of a manipulation of a control (36) of the vehicle (10) by the user (24), and
- adapting the simulation based on the third data (D3).

6. The method according to claim 4 or 5, wherein the simulation comprises a virtual driving environment.

7. The method according to claim 6, wherein the virtual driving environment is at least partially based on a historic real world driving environment.

8. The method according to claim 6, wherein the virtual driving environment is separate from a real-world driving environment.

9. The method of any one of the preceding claims, wherein determining a likelihood (LH) that the user will stay inside the vehicle (10) while the vehicle (10) is in the non-driving mode comprises extrapolating the first data (D1) and/or assessing at least one similarity between the first data (D1) and the second data (D2).

10. The method of any one of the preceding claims, further comprising adjusting the predefined likelihood threshold based on a user reaction to the provision of the description of the functionality of the vehicle (10).

11. The method of any one of the preceding claims, wherein the method is executed after the vehicle (10) has performed a parking maneuver or during a charging procedure or before the start of a drive cycle.

12. A data processing apparatus (34) comprising means (46) for carrying out the method of any one of the preceding claims.

13. A computer program (44) comprising instructions which, when the computer program is executed by a computer, cause the computer to carry out the method of claims 1 to 11.

14. A computer-readable storage medium (42) comprising instructions which, when executed by a computer, cause the computer to carry out the method of claims 1 to 11.

15. A vehicle (10) comprising a data processing apparatus (34) according to claim 12.
